# EUROPÄISCHE PATENTSCHRIFT

(11) **EP 0 257 200 B1**
(45) Veröffentlichungstag und Bekanntmachung des Hinweises auf die Patenterteilung: **28.04.1993**
(21) Anmeldenummer: 87107209.6
(22) Anmeldetag: 18.05.1987
(51) Int. Cl.: G01R 19/00, H03H 19/00, H03K 19/003

(54) **Synchronisierter Messverstärker**
Synchronized measuring amplifier
Amplificateur de mesure synchronisé

(30) Priorität: 14.08.1986 DE 3627610
(43) Veröffentlichungstag der Anmeldung: 02.03.1988
(73) Patentinhaber: Max-Planck-Gesellschaft zur Förderung der Wissenschaften e.V., D-37073 Göttingen (DE)
(72) Erfinder: Schneider, Frank, D-8046 Garching (DE)
(74) Vertreter: von Bezold, Dieter, Dr.

(56) Entgegenhaltungen:
- DE-A- 3 536 731
- US-A- 3 681 701
- US-A- 4 197 515

## Beschreibung

Die vorliegende Erfindung geht aus von einer synchronisierten Meßverstärkeranordnüng mit den im Oberbegriff des Patentanspruchs 1 aufgeführten Merkmalen.

Zur selektiven Verstärkung eines Nutzsignales vorgegebener Frequenz, dem ein Störsignal anderer Frequenz und/oder stochastische Störungen überlagert sind, werden häufig synchronisierte Meßverstärker ("Lock-in-Verstärker") verwendet. Bei diesen bekannten Verstärkern wird das zu verarbeitende Eingangssignal, welches das Nutzsignal und die Störungen enthält, mit einem Referenzsignal korreliert, welches die gleiche Frequenz wie das Nutzsignal hat. Die Korrelation kann mit einer einfachen Umschaltvorrichtung oder auch mit Misch- oder Multiplizierschaltungen erfolgen. Das durch die Korrelation erhaltene Signal muß dann anschließend in einem Tiefpaß von der Referenzfrequenz befreit und geglättet werden, das dabei resultierende Mittelwertsignal ist jedoch abhängig vom Tastverhältnis des Referenzsignals. Der größte Störabstand ergibt sich bei einem Tastverhältnis von 1:1 bzw. einem sinusförmigen Referenzsignal.

Aus dem Dokument US-A-4,197,515 ist ein synchronisierter Meßverstärker (Lock-in-Verstärker) bekannt, der einen Mischer und ein an dessen Ausgang angeschlossenes Tiefpaßfilter enthält. Dem Mischer wird das zu verarbeitende Signal sowie ein Referenzsignal von einem Rechteckschwingungsgenerator zugeführt. Das Tiefpaßfilter enthält eine Mehrzahl von Integrierschaltungen, die parallel zueinander zwischen Eingangs- und Ausgangsschaltvorrichtungen geschaltet sind. Die Schaltvorrichtungen werden durch eine Schaltersteuervorrichtung gesteuert, deren Eingang über einen Frequenzteiler mit dem die Referenzschwingung liefernden Ausgang des Rechteckschwingungsgenerators verbunden ist. Die Integrierschaltungen integrieren nacheinander jeweils Abschnitte des Mischer-Ausgangssignales, welche einem vorgegebenen Bruchteil der Periode der Referenzschwingung entsprechen, und die Ausgangssignale der Integrierschaltungen werden einer Summierschaltung zugeführt, die die von der Ausgangschaltvorrichtung während sukzessiver Zeitinkremente gelieferten Ausgangssignale der Integrierschaltungen additiv zusammensetzt. Der für einen synchronisierten Meßverstärker wesentliche, zur Selektion der Nutzsignalkomponente dienende Teil der Schaltung, der bei diesem Dokument aus einem Mischer besteht, wird als bekannt vorausgesetzt und nicht näher erläutert.

Bei vielen Messungen erhält man ein elektrisches Signal, in dem sich Nutzinformation enthaltende Abschnitte periodisch mit Referenzinformation enthaltenden Abschnitten abwechseln. Häufig ist dabei jedoch eine gleiche Dauer der Nutzinformationsabschnitte und der Referenzinformationsabschnitte, also das Tatstverhältnis 1:1 unmöglich oder nicht sinnvoll, z.B. wenn ein gepulster Prozeß Zeit zur Regenerierung erfordert oder umgekehrt, wenn der Informationsfluß eines Prozesses möglichst kontinuierlich gemessen werden soll und der Nullpunkt nur gelegentlich überprüft werden muß. Für solche Zwecke sind die bekannten Lock-in-Verstärker nicht zweckmäßig. Wenn der getastete Schaltvorgang ein vorübergehendes Übersprechen oder nichtlineare Verzerrungen oder Störungen verursacht, können diese mit den bekannten Lock-in-Verstärkern nicht optimal beseitigt werden.

Durch die im Patentanspruch 1 gekennzeichnete und in den Unteransprüchen weitergebildete Erfindung wird, ausgehend von einem synchronisierten Meßverstärker, wie er aus dem Dokument US-A-4,197,515 bekannt ist, die Aufgabe gelöst, eine synchronisierte Meßverstärkeranordnung gemäß dem Oberbegriff des Patentanspruchs 1 derart weiterzubilden, daß sie anpassungsfähiger ist als die bekannten Meßverstärker und außerdem einen höheren Störabstand aufweist.

Die vorliegende Meßverstärkeranordnung ist nicht nur anpassungsfähiger und zeichnet sich wegen der Möglichkeit der Ausblendung informationsloser oder gestörter Signalabschnitte durch einen höheren Störabstand aus, sie ist ferner einfach im Aufbau, und bevorzugte Ausführungsformen weisen wegen einer individuellen und dadurch optimierbaren Filterung in den verschiedenen Kanälen eine größere Meßdynamik auf.

Die Schaltersteuervorrichtung kann in vorteilhafter Weise für jede Schaltvorrichtung eine Zeitgeberschaltung enthalten, die ein die Schließdauer der betreffenden Schaltvorrichtung steuerndes Signal erzeugt, wobei die Schließdauern unabhängig voneinander einstellbar sein können.

Jeder Signalkanal kann ein eigenes Glättungs- und Speicherglied enthalten, und die Zeitkonstante jedes Glättungs- und Speichergliedes kann einstellbar sein. Die Signalvereinigungsschaltung enthält vorzugsweise einen Differenzverstärker. Der Signalvereinigungsschaltung kann eine eigene Glättungsgliedanordnung zugeordnet sein. Jeder Signalkanal kann einen Trennverstärker enthalten.

Im folgenden werden Ausführungsbeispiele der Erfindung unter Bezugnahme auf die Zeichnungen näher erläutert.

Es zeigen:
- Fig. 1: ein Schaltbild einer bevorzugten Ausführungsform einer synchronisierten Meßverstärkeranordnung gemäß der Erfindung;
- Fig. 2: eine Abwandlung der Schaltungsanordnung gemäß Fig. 1, und
- Fig. 3: ein Diagramm zur Erläuterung der Arbeitsweise der Schaltungsanordnung gemäß Fig. 1.

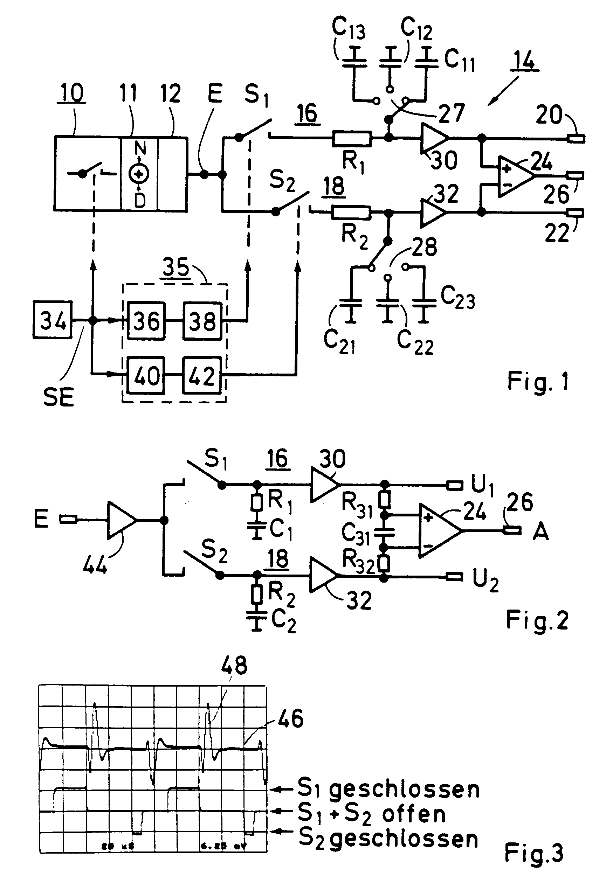

In Fig. 1 ist durch einen Block 10 und das in ihm dargestellte Schaltersymbol ein geschalteter oder getasteter physikalischer oder technischer Prozeß symbolisch dargestellt. Ein interessierender Parameter des Prozesses, dem unvermeidliche Störsignale, wie Rauschen N und Drifteffekte D überlagert sind, wie durch das Addierersymbol im Block 11 symbolisch dargestellt ist, wird durch eine Meßvorrichtung 12 gemessen. Man erhält daher an einer Klemme E ein elektrisches Signal, in dem sich Abschnitte, die die Nutzinformation mit den überlagerten Störungen enthalten, periodisch im Takte der Schaltfrequenz mit Referenzinformation enthaltenden Abschnitten, also Abschnitten, die keine Nutzinformation enthalten, abwechseln.

Zur selektiven Verstärkung der Nutzinformation ist eine mit der Schaltfrequenz des Prozesses 10 synchronisierte Meßverstärkerschaltung 14 gemäß der Erfindung vorgesehen. Die Meßverstärkerschaltung 14 enthält zwei getrennte Kanäle 16 und 18, deren Eingänge jeweils über einen eigenen Schalter S₁ bzw. S₂ mit der Klemme E verbunden sind, die also als Eingangsklemme der Meßverstärkerschaltung angesehen werden kann. Die Ausgänge der Kanäle 16 und 18 sind einerseits mit Ausgangsklemmen 20 bzw. 22 und andererseits mit dem nichtinvertierenden bzw. invertierenden Eingang eines Differenzverstärkers 24 verbunden, der an einer weiteren Ausgangsklemme 26 ein Differenzsignal erzeugt.

Die Kanäle enthalten jeweils ein Speicher- und Glättungsglied in Form eines Integriergliedes aus einem Längswiderstand R1 bzw. R2 und einem mittels eines Schalters 27 bzw. 28 wahlweise einschaltbaren Querkondensator C11, C12 oder C13 bzw. C21, C22 bzw. C23. Auf die Integrierglieder folgt jeweils ein Trennverstärker 30 bzw. 32. Die Ausgänge der Trennverstärker sind jeweils mit einer der Ausgangsklemmen 20, 22 und mit einem Eingang des Differenzverstärkers 24 verbunden. An den Ausgangsklemmen 20, 22 steht jeweils eine durch den zugehörigen Schalter S₁ bzw. S₂ ausgewählte Information zur Verfügung.

Die Schalt- oder Tastfrequenz des Prozesses 10 wird durch einen Taktgeber 34 in der gewünschten Weise periodisch oder gegebenenfalls auch aperiodisch gesteuert. Das Ausgangssignal des Taktgebers steuert eine Schaltersteuervorrichtung 35, deren Eingangsanschluß mit SE bezeichnet ist. Bei der vorliegenden Schaltersteuervorrichtung 35 steuert das Ausgangssignal des Taktgebers 34 über ein einstellbares Verzögerungsglied 36 und einen einstellbaren Zeitgeber 38 den Zeitpunkt und die Dauer des Schließens des Schalters S₁ sowie über ein zweites einstellbares Verzögerungsglied 40 und einen zweiten Zeitgeber 42 den Einschaltzeitpunkt und die Einschaltdauer des Schalters S₂. Die Verzögerungsglieder und Zeitgeber können beispielsweise aus Monoflops, d.h. monostabilen Multivibratorschaltungen, bestehen. Durch die Verzögerungsglieder 36, 40 kann also der zeitliche Abstand zwischen der Vorder- oder Rückflanke des den Prozeß 10 steuernden Tastimpulses vom Taktgeber 34 und dem Schließen des Schalters S₁ bzw. S₂ beliebig eingestellt werden. Durch die Zeitgeber 38 und 42 läßt sich die Schließdauer der Schalter S₁ und S₂ unabhängig voneinander einstellen.

Man ist dadurch in der Auswahl der Abschnitte des Eingangssignales an der Klemme E, welche dem Kanal 16 bzw. dem Kanal 18 zugeführt werden, völlig frei und kann auch das Tastverhältnis der Signalabschnitte, die den beiden Kanälen zugeführt werden, beliebig wählen.

Die mittels der Schalter S₁ und S₂ ausgewählten Signalabschnitte werden über die Glättungswiderstände R1 bzw. R2 den Kondensatoren des Integriergliedes zugeführt und dort gespeichert. An den Ausgängen 20 bzw. 22 steht jeweils der Mittelwert der abgegriffenen Signale zur Verfügung. Da die Schaltstörungen des Prozesses 10 selbst nun nicht mehr ausgefiltert werden müssen, können die Glättungszeitkonstanten R1, C1 bzw. R2, C2 beliebig gewählt werden, sie lassen sich also der Art des hochfrequenten Rauschens im Meßsignal optimal anpassen. Dadurch kann eine wesentliche Steigerung der Meßdynamik erzielt werden, insbesondere bei Vorgängen, die nur eine relativ niedrige Abtastfrequenz zulassen. Die an den Ausgängen 20 und 22 auftretenden "Phasenwerte" U1 bzw. U2 stehen getrennt als zusätzliche Information zur Verfügung.

Die in Fig. 2 dargestellte, abgewandelte Ausführungsform der Meßverstärkerschaltung unterscheidet sich von der Meßverstärkerschaltung 14 gemäß Fig. 1 im wesentlichen in folgender Hinsicht: Zwischen die Eingangsklemme E und die Schalter S₁, S₂ ist ein zusätzlicher Trennverstärker 44 geschaltet. Die Speicherglieder bestehen aus einer Serienschaltung eines Widerstandes R1 und eines Kondensators C1 bzw. R2, C2, die zwischen die Verbindung zwischen dem Schalter S₁ bzw. S₂ und dem zugehörigen Verstärker 30 bzw. 32 einerseits und Masse andererseits geschaltet ist. Ferner ist an den Eingang des Differenzverstärkers eine Glättungs- oder Siebschaltung angeschlossen, welche einen Widerstand R31, der zwischen den Ausgang des Verstärkers 30 und den nichtinvertierenden Eingang des Differenzverstärkers 24 geschaltet ist, ferner einen Widerstand R32, der zwischen den Ausgang des Verstärkers 32 und den invertierenden Eingang des Differenzverstärkers geschaltet ist, sowie einen Kondensator C31, der zwischen die Eingänge des Differenzverstärkers geschaltet ist, enthält, der beiden Integriergliedern gemeinsam ist und daher den doppelten Kapazitätswert wie für ein einzelnes Siebglied hat. Hier sind also die Speicher- oder Integrierfunktion einerseits und die Siebfunktion zur Unterdrückung des hochfrequenteren Rauschens N andererseits getrennt und nicht, wie bei Fig. 1, durch ein und dasselbe Integrierglied RC realisiert. Außerdem steht bei der Schaltung gemäß Fig. 2 während der Schließdauer der Schalter jeweils der abgegriffene Signalwert am Ausgangsanschluß des betreffenden Kanals unverzögert zur Verfügung, während bei geöffnetem Schalter der Mittelwert der abgegriffenen Signalabschnitte auftritt.

Fig. 3 zeigt ein Oszillogramm 46 eines typischen elektrischen Eingangssignales, wie es z. B. von einem getasteten HeißkathodenIonisationsmanometer der Klemme E der vorliegenden synchronisierten Meßverstärkeranordnung zugeführt wird. Das Eingangssignal enthält verhältnismäßig große Schalt-Störimpulse 48, deren Amplitude hier mehr als das Zehnfache der Nutzsignalamplitude beträgt.

Die untere Kurve zeigt die Schaltzustände der beiden Schalter S₁ und S₂. Die Meßverstärkerschaltung 14 gemäß Fig. 1 lieferte für das Eingangssignal 46 gemäß Fig. 3 am Ausgang 26 des Differenzverstärkers eine völlig glatte Ausgangsspannung A von 10 Volt.

Die beschriebenen Ausführungsbeispiele lassen sich beispielsweise dadurch abwandeln, daß mehr als zwei Schalter und Signalkanäle, denen jeweils paarweise ein Differenzverstärker zugeordnet ist, verwendet werden. Man kann auch zwei oder mehr Meßverstärkerschaltungen der beschriebenen Art parallel betreiben, wenn mehr als zwei Phasenzustände zu erfassen sind.

## Patentansprüche

1. Synchronisierte Meßverstärkeranordnung zur Selektion einer periodisch oder aperiodisch auftretenden Nutzinformationskomponente eines Eingangssignales, das die Nutzinformationskomponente und Störungen enthält, mit
- einem Eingangsanschluß (E) für das Eingangssignal,
- einem Synchronisierungssignal-Eingangsanschluß (SE) für ein mit der Nutzinformationskomponente des Eingangssignales synchrones Synchronisierungssignal, und
- einer mit dem Eingangssignal-Eingangsanschluß sowie dem Synchronisierungssignal-Eingangsanschluß (SE) gekoppelten Korrelierungsschaltung zum Korrelieren des Eingangssignales mit dem Synchronisierungssignal,
**dadurch gekennzeichnet**, daß die Korrelierungsschaltung enthält:
- einen ersten und einen zweiten Signalkanal (16, 18), die jeweils einen Eingang und einen Ausgang aufweisen,
- eine erste und eine zweite Schaltvorrichtung (S₁, S₂), die zwischen den Eingangsanschluß (E) für das Eingangssignal und den Eingang des ersten bzw. des zweiten Signalkanales geschaltet sind und jeweils einen Steuereingang aufweisen,
- eine Schaltersteuervorrichtung (35), welche an den Synchronisierungssignal-Eingangsanschluß (SE) angeschlossen ist, an die Steuereingänge der Schaltvorrichtungen (S₁, S₂) zeitlich in Bezug aufeinander versetzte, mit der Nutzinformation synchronisierbare Schaltsignale liefert, für jede Schaltvorrichtung (S₁, S₂) ein einstellbares Verzögerungsglied (36, 40) enthält und die Schließzeitpunkte der Schaltvorrichtungen (S₁, S₂) unabhängig voneinander einzustellen gestattet, und
- eine zwischen die Ausgänge des ersten und des zweiten Signalkanals (16, 18) und einen Meß-Verstärker-Ausgangsanschluß (26) gekoppelte Signalvereinigungsschaltung (24), die die Signale, die am Ausgang des ersten und am Ausgang des zweiten Signalkanales (16, 18) auftreten, subtraktiv vereinigt.

2. Meßverstärkeranordnung nach Anspruch 1, **dadurch gekennzeichnet**, daß die Schaltsteuervorrichtung (35) für jede Schaltvorrichtung (S₁, S₂) eine Zeitgeberschaltung (38, 42) enthält, die ein die Schließdauer der betreffenden Schaltvorrichtung (S₁, S₂) steuerndes Signal erzeugt.

3. Meßverstärkeranordnung nach Anspruch 2, **dadurch gekennzeichnet**, daß die Dauern der das Schließen der Schaltvorrichtungen (S₁, S₂) steuernden Signale der Zeitgeberschaltungen (38, 42) unabhängig voneinander einstellbar sind.

4. Meßverstärkeranordnung nach einem der vorhergehenden Ansprüche, **dadurch gekennzeichnet**, daß jeder Signalkanal ein eigenes Glättungs- und Speicherglied (R1, C1; R2, C2) enthält.

5. Meßverstärkeranordnung nach Anspruch 4, **dadurch gekennzeichnet**, daß die Zeitkonstante jedes Glättungs- und Speichergliedes einstellbar ist.

6. Meßverstärkeranordnung nach einem der vorhergehenden Ansprüche, **dadurch gekennzeichnet**, daß die Signalvereinigungsschaltung (24) einen Differenzverstärker enthält.

7. Meßverstärkeranordnung nach einem der vorhergehenden Ansprüche, **dadurch gekennzeichnet**, daß der Signalvereinigungsschaltung (24) eine eigene Glättungsgliedanordnung (R31, R32, C31) zugeordnet ist.

8. Meßverstärkeranordnung nach einem der vorhergehenden Ansprüche **dadurch gekennzeichnet**, daß jeder Signalkanal (16, 18) zusätzlich mit einem eigenen Kanal-Ausgangsanschluß (20, 22) gekoppelt ist.

9. Meßverstärkeranordnung nach einem der vorhergehenden Ansprüche, **dadurch gekennzeichnet**, daß jeder Signalkanal (16, 18) einen Trennverstärker (30, 32) enthält.

## Claims

1. A synchronised measuring amplifier arrangement for selecting a periodically or aperiodically occurring useful information component of an input signal which contains the useful information component and noise, comprising:
- an input terminal (E) for the input signal,
- a synchronising signal input terminal (SE) for a synchronising signal synchronous with the useful information component of the input signal, and
- a correlation circuit coupled to the input signal input terminal and to the synchronising signal input terminal (SE), for correlating the input signal with the synchronising signal,
characterized in that the correlation circuit includes:
- first and second signal channels (16, 18), each having an input and an output,
- first and second switch devices (S₁, S₂) which are connected between the input terminal (E) for the input signal and the inputs of the first and the second signal channels respectively and which each have a control input,
- a switch control device (35) which is connected to the synchronising signal input terminal (SE), provides mutually time-shifted switching signals to the control inputs of the switching devices (S₁, S₂), which signals can be synchronised with the useful information, includes an adjustable delay element (36, 40) for each switch device (S₁, S₂) and allows independent adjustment of the switching times of the switch elements (S₁, S₂), and
- a signal combining circuit (24) coupled between the outputs of the first and second signal channels (16, 18) and a measuring amplifier output terminal (26) and which combines subtractively the signals which appear at the output of the first signal channel (16) and at the output of the second signal channel (18).

2. A measuring amplifier arrangement according to claim 1, characterized in that the switch control device (35) includes for each switch device (S₁, S₂) a timing circuit (38, 42) which generates a signal controlling the closing duration of the respective switch device (S₁, S₂).

3. A measuring amplifier arrangement according to claim 2, characterized in that the durations of the signals of the timimg circuits (38, 42) controlling the closure of the switch devices (S₁, S₂) are independently adjustable.

4. A measuring amplifier arrangement according to any of the preceding claims, characterized in that each signal channel includes its own smoothing and storage element (R1, C1; R2, C2).

5. A measuring amplifier arrangement according to claim 4, characterized in that the time constant of each smoothing and storage element is adjustable.

6. A measuring amplifier arrangement according to any of the preceding claims, characterized in that the signal combining circuit (24) comprises a differential amplifier.

7. A measuring amplifier arrangement according to any of the preceding claims, characterized in that the signal combining circuit (24) has its own associated smoothing element arrangement (R31, R32, C31).

8. A measuring amplifier arrangement according to any of the preceding claims, characterized in that each signal channel (16, 18) is additionally coupled to its own channel output terminal (20, 22).

9. A measuring amplifier arrangement according to any of the preceding claims, characterized in that each signal channel (16, 18) includes a buffer amplifier (30, 32).

## Revendications

1. Agencement d' amplificateur de mesure synchronisé destiné à la sélection d'une composante d'information utile, à occurrence périodique ou apériodique, d'un signal d' entrée contenant les composantes d'information utile et des parasites, avec :
- un raccordement d'entrée (E pour le signal d'entrée,
- un raccordement d'entrée (SE) de signal de synchronisation, pour un signal de synchronisation synchrone avec la composante d'information utile du signal d'entrée, et
- un circuit de corrélation, couplé au raccordement d'entrée de signal d'entrée ainsi qu'au raccordement d'entrée (SE) de signal de synchronisation, en vue d'assurer la corrélation entre le signal d'entrée et le signal de synchronisation,
caractérisé en ce que le circuit de corrélation contient :
- un premier et un deuxième canal de signal (16,18), présentant chacun une entrée et une sortie,
- un premier et un deuxième dispositif de commutation (S₁,S₂), mis en circuit entre le raccordement d'entrée (E) destiné au signal d'entrée et à l'entrée du premier, ou du deuxième canal de signal et présentant chaque fois un entrée de commande,
- un dispositif de commande de commutateur (35), raccordé au raccordement d'entrée (SE) du signal de synchronisation, et envoyant aux entrées de commande des dispositifs de commutation (S₁,S₂) des signaux de commutation, décalés temporellement entre eux, susceptibles d'être synchronisés avec l'information utile et contenant pour chaque dispositif de commutation (S₁,S₂) un élément de temporisation (36,40) réglable et permettant de régler indépendamment les uns des autres les moments des fermetures des dispositifs de commutation (S₁,S₂), et
- un circuit d'union de signaux (24), couplé entre les sortie des premier et deuxième canaux de signal (16,18) et un raccordement de sortie d'amplificateur de mesure (26), opérant une unification soustractive des signaux venant à la sotie du premier et à la sortie du deuxième canal de signal (16,18).

2. Agencement d'amplificateur de mesure selon la revendication 1, caractérisé en ce que le dispositif de commande de commutation (35) de chaque dispositif de commutation (S₁,S₂) contient un circuit de synchronisation (38,42) qui produit un signal commandant la fermeture du dispositif de commutation (S₁,S₂) correspondant.

3. Agencement d' amplificateur de mesure selon la revendication 2 caractérisé en ce que la durée des signaux commandant la fermeture des circuits de commutation (S₁,S₂), des circuits de synchronisation (38,42) peut être réglée indépendamment l'un de l'autre.

4. Agencement d'amplificateur de mesure selon l'une des revendications précédentes, caractérisé en ce que chaque canal de signaux contient un composant de filtrage et de mémorisation (R1,C1; R2,C2) qui lui est propre.

5. Agencement d' amplificateur de mesure selon la revendication 4, caractérisé en ce que la constante de temps de chaque composant de filtrage et de mémorisation est réglable.

6. Agencement d'amplificateur de mesure selon l'une des revendications précédentes, caractérisé en ce que le circuit d'union de signaux (24) comporte un amplificateur différentiel.

7. Agencement d'amplificateur de mesure selon l'une des revendications précédentes caractérisé en ce qu'au circuit d'union de signaux (24) est associé un agencement d'éléments de filtrage (R1,C1; R2,C2) qui lui est propre.

8. Agencement d'amplificateur de mesure selon l'une des revendications précédentes caractérisé en ce que chaque canal de signaux (16,18) est en plus couplé avec un raccordement de sortie de canal (20,22) qui lui est propre.

9. Agencement d'amplificateur de mesure selon l'une des revendications précédentes caractérisé en ce que chaque canal de signaux (16,18) comporte un ampliséparateur (30,32).
